Europäisches Patentamt

European Patent Office

Office européen des brevets

(19)

(11) EP 0 616 420 B1

(12) **FASCICULE DE BREVET EUROPEEN**

(45) Date de publication et mention
de la délivrance du brevet:
**04.12.1996 Bulletin 1996/49**

(51) Int Cl.6: **H03F 1/02**

(21) Numéro de dépôt: **94400511.5**

(22) Date de dépôt: **09.03.1994**

(54) **Amplificateur à fréquence intermédiaire embarqué, récepteur embarqué de signaux comme une télécommande**

Zwischenfrequenz-Bordverstärker und Bordempfänger für Fernbedienungssignale

Onboard I.f. amplifier, onboard receiver for telecontrol signals

(84) Etats contractants désignés:
**DE ES GB IT**

(30) Priorité: **19.03.1993 FR 9303191**

(43) Date de publication de la demande:
**21.09.1994 Bulletin 1994/38**

(73) Titulaire: **VALEO ELECTRONIQUE**
**94042 Creteil Cédex (FR)**

(72) Inventeur: **Rydel, Charles**
**F-75019 Paris (FR)**

(74) Mandataire: **Gamonal, Didier et al**
**Valeo Management Services**
**Sce Propriété Industrielle**
**2, rue André Boulle**
**B.P. 150**
**94004 Créteil (FR)**

(56) Documents cités:
**GB-A- 2 072 979      US-A- 2 994 833**
**US-A- 3 566 293**

**Description**

La présente invention concerne un amplificateur à fréquence intermédiaire à faible consommation, ainsi qu'un récepteur embarqué de signaux muni d'un tel amplificateur. Un tel récepteur peut être constitué par un récepteur de télécomande par exemple pour l'ouverture des portes d'un véhicule.

Dans l'art antérieur, on a déjà proposé de travailler en modulation angulaire, comme une modulation de fréquence pour transmettre des informations numériques à une machine de traitement de l'information.

Quand la machine est constituée par un module de bord destiné à recevoir les signaux d'une télécommande radio-fréquence d'ouverture ou de fermeture des accès d'un véhicule, la consommation du module de bord est un problème majeur.

En effet, le module de bord doit rester en veille pendant toute sa durée de vie de façon à passer en mode actif dès réception d'une onde radio-fréquence convenable.

Or, le dispositif placé à l'entrée du module de bord doit être capable d'amplifier les signaux reçus sur une antenne de réception dont le gain est forcément limité par l'encombrement réduit dont on dispose.

De plus, l'organe émetteur est constitué par une clé portable à la disposition du propriétaire du véhicule et cette clé comporte un émetteur dont la puissance rayonnée est elle-même faible, puisqu'elle doit comporter une source d'énergie, un circuit électronique de gestion et une antenne d'émission dans un format très réduit comme celui d'une carte de crédit ou de la tête de clé mécanique d'un antivol de voiture.

Le dispositif d'entrée du module de bord doit donc être constitué par un montage électronique à très hautes performances et dont la consommation doit être aussi réduite que possible.

Il existe des montages peu consommateurs d'énergie. Mais, leur sélectivité est alors réduite ce qui les rend impropres à résoudre le problème précité.

On connaît une structure de dispositif d'entrée dit à fréquence intermédiaire, mais, ce dernier comporte au moins deux étages pour réaliser la sélection et le décodage de la modulation reçue. De ce fait, la consommation d'un tel montage est élevée puisqu'il faut polariser deux étages successifs.

Dans une demande de brevet précédente, du même jour, le déposant a proposé une solution de montage de plusieurs étages d'un dispositif qui réduit considérablement la consommation électrique.

La présente invention consiste à adapter cette disposition à un amplificateur à fréquence intermédiaire de consommation réduite. L'amplificateur à fréquence intermédiaire est tel que définis par la revendication 1.

L'invention concerne aussi un récepteur de signaux comme une télécommande, embarqué à bord d'un véhicule notamment, et équipé au moins d'un dispositif selon l'invention.

D'autres caractéristiques et avantages de la présente invention apparaîtront plus clairement à l'aide de la description et des dessins qui sont :

- la figure 1 : un schéma représentant un moyen général de réduction de la consommation électrique adapté à un amplificateur à fréquence intermédiaire selon l'invention ;
- la figure 2 : un schéma représentant un moyen supplémentaire permettant de réaliser une correction électrique sur le moyen de la figure 1 ;
- la figure 3 : un schéma d'un amplificateur à fréquence intermédiaire selon l'invention ;
- les figures 4 et 5 : deux variantes d'exécution de parties de montage de la figure 3 ;
- la figure 6 : un schéma de principe d'une correction automatique destinée à l'amplificateur de la figure 4 ;
- la figure 7 : le schéma d'un mode de réalisation de la correction automatique de la figure 6.

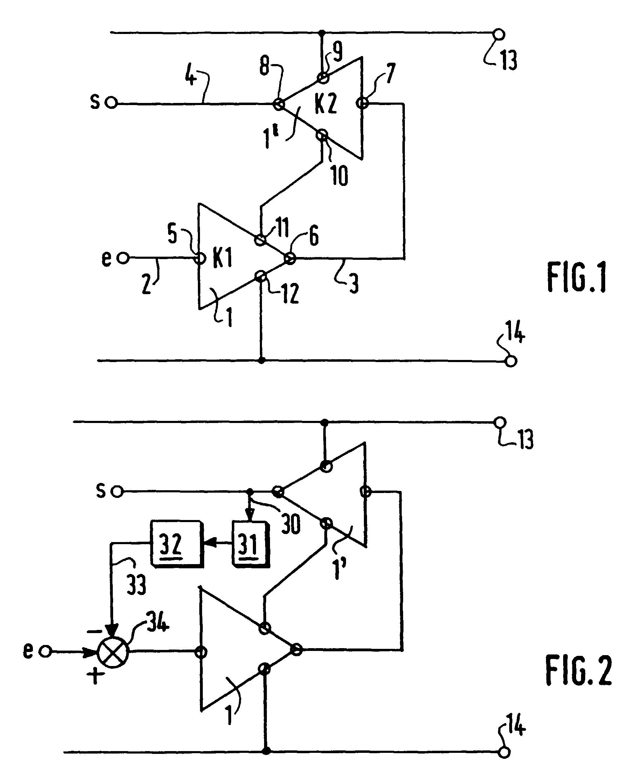

La figure 1 est un schéma représentant un moyen général de réduction de la consommation électrique adapté à un amplificateur à fréquence intermédiaire selon l'invention.

Un tel montage comporte principalement un premier étage 1 et un second étage 1', qui comportent respectivement une borne d'entrée de signal 5 ou 7 et une borne de sortie de signal 6 ou 8, ainsi que des bornes d'alimentation en tension continue respectivement 9 et 11 pour le potentiel haut ou positif, et 10 et 12 pour le potentiel bas ou négatif.

La borne d'entrée de signal du dispositif, référencée e, est transmise par une liaison 2 à la borne d'entrée de signal 5 du premier étage 1. La borne de sortie de signal 6 du premier étage 1 est connectée par une liaison 3 à la borne d'entrée de signal 7 du second étage 1'. La borne de sortie de signal 8 du second étage 1' est connectée par une liaison 4 à la borne de sortie de signal s du dispositif de l'invention.

Dans un tel moyen, bien que les étages 1 et 1' soient, au point de vue du signal, montés en cascade, les étages 1 et 1' sont montés en série entre une première borne d'alimentation 13 de potentiel haut (ou positif) et une seconde borne 14 d'alimentation de potentiel bas (ou négatif). A cette fin, le second étage 1' est connecté par sa borne 9 d'alimentation positive à la borne d'alimentation 13 de potentiel haut (ou positif), tandis que sa borne 10 d'alimentation négative ou nulle est connectée à la borne 11 d'alimentation positive du premier étage 1, dont la borne 12 d'alimentation négative est connectée à la borne d'alimentation 14 de potentiel bas (ou négatif).

Si on pose que les résistances équivalentes d'alimentation, en l'absence de signal par exemple, dans le dispositif électronique sont respectivement R1 entre les bornes 11 et 12 pour le premier étage 1 et R2 entre les bornes 9 et 10 pour le deuxième étage 1', et en désignant par Ua la tension d'alimentation continue entre les bornes 13 et 14, on remarque que la puissance consommée peut s'écrire $P = Ua^2 / (R1 + R2)$.

En suivant l'enseignement de l'art antérieur, on remarque que les bornes d'alimentation positive respectivement 11 et 9, des premier 1 et second 1 étages seraient connectées toutes les deux à la ligne 13, tandis que les bornes d'alimentation négative, respectivement 12 et 10, seraient connectées en commun à la ligne 14. Dans ce cas, la puissance consommée serait supérieure et s'exprimerait par :

$$P = Ua^2/R1 + Ua^2/R2$$

Dans le moyen utilisé par la présente invention, il est possible d'augmenter le nombre des étages, dans la limite où la différence de tension, entre les bornes de plus haute tension continue et de plus basse tension continue, est suffisante pour chacun des étages de façon à polariser convenablement le montage.

Dans le dispositif de la figure 1, le signal de sortie produit s'écrit $S(p) = K1 \times K2 \, E(p)$

si K1 et K2 désignent les fonctions de transfert des étages 1 et 1', et E(p) et S(p) les transformées de Laplace des signaux d'entrée e et de sortie s du dispositif.

Le moyen décrit à la figure 1 est appliqué au cas où les étages 1 et 1' sont des amplicateurs.

A la figure 2, on a représenté un moyen supplémentaire adapté au montage de la figure 1. Dans ce dispositif, on suppose que les étages 1 et 1' sont des amplificateurs de tension. Ils sont connectés comme il est représenté à la figure 1 et leur connexion à l'alimentation continue n'est pas décrite plus avant. On réalise à l'aide du montage de la figure 2, une correction automatique de gain CAG en réalisant par une connexion 30 une détection du signal de sortie s en sortie du second étage 1'.

Le moyen supplémentaire de l'invention comporte un circuit détecteur 31 dont le signal de sortie commande un générateur de signal de la correction automatique de gain 32 qui est connecté par une liaison 33 à un élément d'addition 34 sur la voie d'entrée e. Le signal d'entrée e est transmis par exemple à une borne d'alimentation positive, référencée + au dessin, de l'additionneur 34, tandis que le signal de sortie de la correction automatique de gain est connecté à une borne négative, référencée - au dessin, de l'additionneur 34. Dans le mode de réalisation représenté à la figure 2, la correction automatique de gain travaille de manière négative.

Il est possible d'appliquer la correction automatique de gain sur une partie seulement de la bande passante du signal de sortie s, en utilisant un filtre passe-bande sur la voie 30.

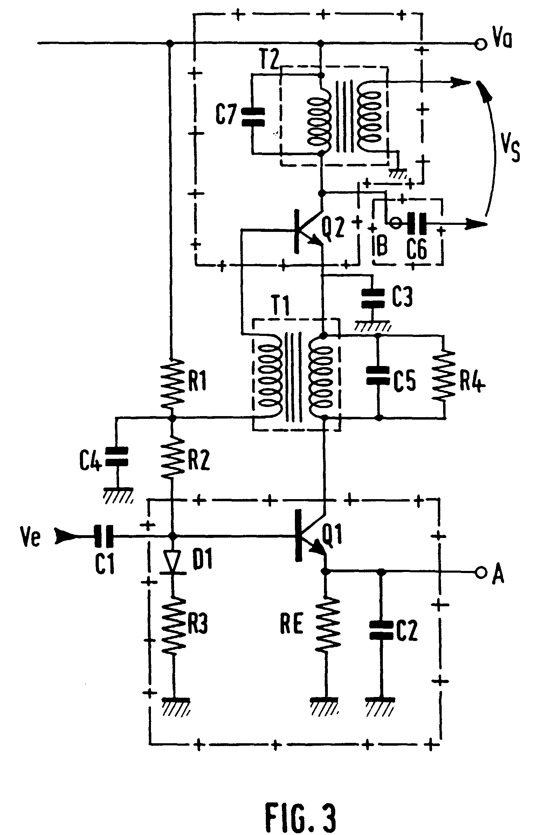

A la figure 3, on a représenté un amplificateur à fréquence intermédiaire mettant en oeuvre le principe de l'invention décrit à la figure 1.

Un tel amplificateur doit être alimenté en permanence de façon à recevoir le signal d'entrée Ve qui est transmis par un condensateur de liaison C1, qui coupe la composante continue, à un premier étage amplificateur constitué par un transistor Q1 de type NPN et un second étage amplificateur constitué par un transistor Q2 de type NPN. L'émetteur du transistor Q1 est relié à la masse par un réseau de découplage, constitué par une résistance RE connectée en parallèle avec un condensateur C2. La base du transistor Q1 est polarisée par la ligne d'alimentation Va de potentiel haut (ou positif), en série à travers une résistance de polarisation R1, la polarisation de la base du transistor Q2 d'amplification de second étage, et une seconde résistance de polarisation R2 qui est connectée aussi à la base du transistor Q1. La polarisation est complétée par une diode D1 de compensation, connectée en série avec une résistance R3 permettant de s'ajuster à la tension Vbe base émetteur du transistor Q1, connectée à la masse, servant de ligne d'alimentation de potentiel bas (ou nul).

Du fait du montage, les transistors Q1 et Q2 étant identiques, ils partagent le même courant et utilisent chacun la moitié de la tension d'alimentation disponible.

Les résistances R1,R2 et R3 fixent les potentiels sur les bases de Q1 et de Q2 et donc aussi sur les émetteurs. Dans ces conditions, la tension Vel aux bornes de la résistance RE est exprimée, en négligeant les courants de base, par :

$$Ve1 = Va \times R3 / (R1 + R2 + R3) - Vebe$$

et le courant traversant les transistors T1 et T2 est égal à Ve1 / RE. Q1 est donc un générateur de courant pour Q2.

L'émetteur du transistor Q2 est connecté au collecteur du transistor Q1 par le circuit secondaire d'un transformateur T1 qui est constitué par le bobinage secondaire du transformateur T1, le condensateur C5 et une résistance R4 connectés en parallèle.

La tension sur l'émetteur du transistor Q2 est exprimée par :

$$Ve2 = Va (R2 + R3) / (R1 + R2 + R3) - Vbe.$$

Cette tension alimente le transistor T1 par l'intermédiaire du transformateur T1.

Le transistor Q2 constitue donc un générateur de tension de résistance de sortie Ro (Q2) faible, égale à :

$$Ro(Q1) = 1 / K2.Ic(Q2)$$

où K2 est le gain du transistor Q2 et Ic(Q2) est le courant traversant le transistor Q2, qui vaut :

$$Ic(Q2) = Ic(Q1) = Ve/RE.$$

De ce fait, le transistor Q1 travaille en source de courant et le transistor Q2 alimente le transistor Q1 sous forme d'une source de tension.

Le secondaire du transformateur T1 comporte une première borne connectée au point commun entre les résistances de polarisation R1 et R2 et une seconde borne connectée à la base du transistor Q2.

D'autre part, le collecteur du transistor Q2 est connecté par l'intermédiaire d'un second transformateur T2 à la ligne d'alimentation de potentiel haut Va. Le primaire du transformateur T2 est connecté en parallèle avec un condensateur C7, tandis que le point froid du primaire est connecté au collecteur de Q2. Le collecteur de Q2 sert de sortie B au signal de sortie de l'amplificateur à fréquence intermédiaire. Le secondaire du transformateur T2 comporte une première borne connectée à la masse et une seconde borne qui sert de masse flottante à la tension de sortie Vs de l'amplificateur à fréquence intermédiaire. Le signal progresse donc de l'entrée Ve à la sortie B par la base de Q1, le collecteur de Q1, le transformateur T1, la base de Q2 et le collecteur de Q2.

De façon à réaliser une bonne sélectivité de l'amplificateur à fréquence intermédiaire, les transformateurs T1 et T2 sont accordés de manière convenable en fonction des bandes passantes désirées et des courbes ou fonctions de transfert désirées.

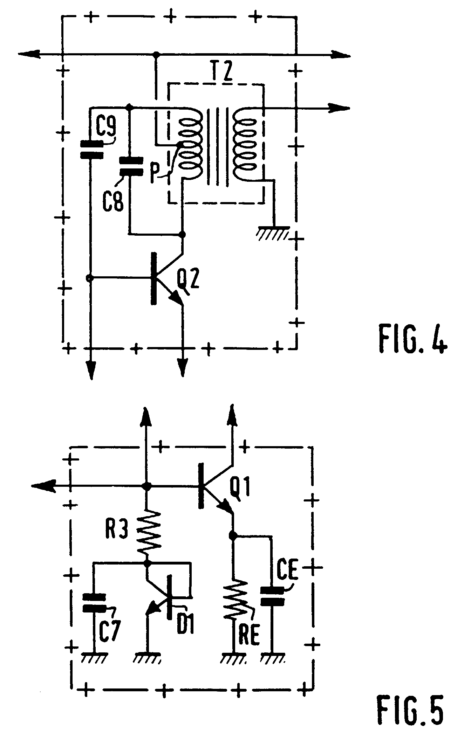

Au point de vue du signal fréquenciel introduit sur l'entrée Ve de l'amplificateur de la figure 4, le transistor Q1 voit une source d'alimentation Q2 découplée par le condensateur C3. Pour obtenir cette caractéristique, on choisit la capacité du condensateur C3 de façon à ce qu'il présente à la fréquence intermédiaire choisie une impédance beaucoup plus petite que l'impédance de sortie du transistor Q2.

Ainsi qu'on l'a vu, les signaux amplifiés par le transistor Q1 sont couplés au transistor Q2 par le secondaire du transformateur T1 dont une extrémité est à la masse au point de vue haute fréquence par l'intermédiaire du condensateur C4.

L'émetteur du transistor Q2 et la base du transistor Q2 étant à la masse, il en résulte que la tension sur le secondaire de T1 est appliquée entre la base et l'émetteur du transistor Q2. Cette tension est amplifiée par le transistor Q2. Elle peut, selon le cas, être utilisée soit à partir d'une liaison capacitive du collecteur de Q2 soit à partir du secondaire du transformateur T2.

A titre de variante, on a représenté à la figure 4 un schéma dans lequel le transformateur T2 a été neutrodyné. Dans ce montage, le primaire du transformateur T2 comporte une prise P de point milieu qui est connectée à la ligne d'alimentation à potentiel positif par une liaison directe. Les deux bornes de l'enroulement primaire sont montées en parallèle avec un premier condensateur C8. Une première borne de l'enroulement primaire est connectée à la base du transistor Q2 par l'intermédiaire d'un condensateur C9 tandis qu'une seconde borne est connectée au collecteur de Q2.

Le dispositif présente aussi une résistance R4 aux bornes du secondaire du transformateur T1 qui sert à amortir ce transformateur afin, qu'en décalant les accords des transformateurs T1 et T2, on puisse obtenir une réponse en bande plate en présentant une ondulation prédéterminée. On peut aussi choisir une résistance R4 telle que le temps de propagation de groupe soit constant.

La diode D1 sert à compenser en température la jonction base-émetteur du transistor Q1. De cette façon, on empêche que la dispersion en température soit importante.

A la figure 5, on a représenté une variante de montage du transistor Q1 à compensation en température. La diode D1 est ici constituée par un transistor identique au transistor Q1 dont la base et le collecteur sont court-circuités. On a disposé un condensateur C7 en parallèle avec le chemin collecteur-émetteur de la diode D1. L'émetteur et une extrémité du condensateur C7 sont connectés à la masse. Le collecteur de la diode D1 est connecté à la base du transistor Q1 par l'intermédiaire de la résistance de polarisation R3.

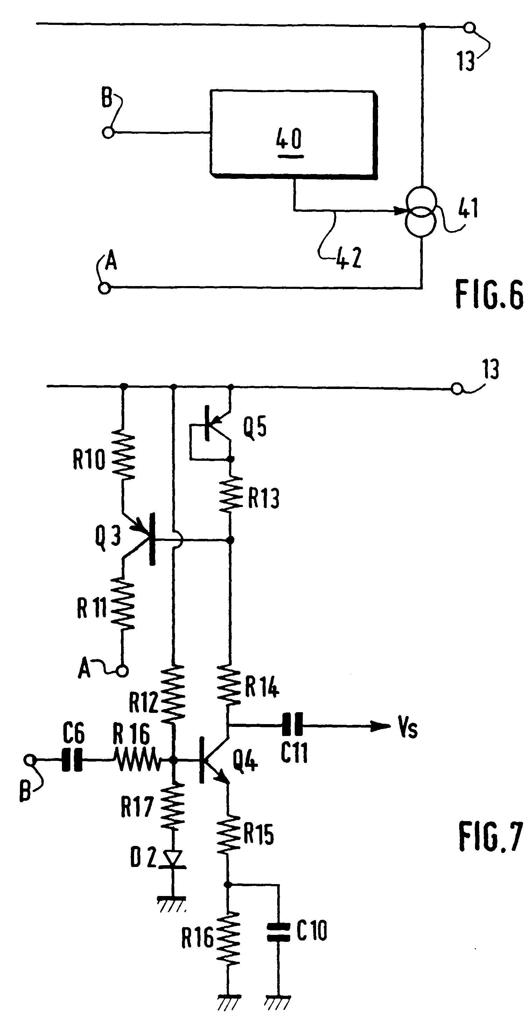

A la figure 6, on a représenté un autre montage qui permet de réaliser une correction automatique de gain CAG sur l'amplificateur à fréquence intermédiaire. Dans le montage de la figure 3, il suffit de diminuer le courant dans le transistor Q1 pour diminuer réciproquement celui dans le transistor Q2. La variation de courant est réalisée à l'aide d'un dispositif 40 de détection de niveau, qui reçoit le signal de sortie prélevé sur la connexion B de la figure 3 et qui produit un signal de sortie de détection 42 qui sert à contrôler une source de courant 41 connectée entre la ligne d'alimentation de potentiel haut (ou positif) 14 et le point A de sommation des courants sur le transistor Q1. Quand on veut réaliser une correction automatique de gain à l'aide du montage de la figure 6, il suffit d'augmenter plus ou moins l'extraction de courant vers l'alimentation et on élève ainsi le potentiel Ve, et comme la tension Vb reste fixe, le courant de collecteur diminue dans le transistor Q1 et donc dans le transistor Q2.

A la figure 7, on a représenté un mode de réalisation pratique de la correction automatique de gain CAG d'un amplificateur à fréquence intermédiaire adapté à un récepteur de signaux de télécommande. Le schéma de la figure 7 se connecte directement sur le point de connexion B du schéma de la figure 3 ainsi que sur le point A du même schéma. Le signal de sortie de l'amplificateur de la figure 3 est capté au point B et transmis par un circuit série constitué d'un condensateur C6 et d'une résistance R16 à la base d'un transistor Q4.

Le transistor Q4 est polarisé à l'aide d'une résistance R12 et d'une résistance R17 en série avec une diode D2. L'émetteur du transistor Q4 est connecté à la masse par l'intermédiaire d'une résistance R15 et d'un circuit parallèle constitué d'une résistance R16 et d'un condensateur C10 de découplage partiel d'émetteur.

Le collecteur du transistor Q4 est connecté à l'alimentation de plus haute tension continue 13 par l'intermédiaire d'une résistance R14, en série avec une résistance R13, et un transistor Q5, monté en diode de compensation, sa base et son collecteur étant court-circuités.

D'autre part, le point commun entre la résistance R14 et la résistance R13, est connecté à la base d'un transistor Q3 de type PNP opposé au type NPN du transistor Q4, dont le chemin émetteur collecteur est connecté entre la plus haute tension continue 13 par une résistance R10 à l'émetteur, et le collecteur est connecté au point A par l'intermédiaire d'une résistance R11.

Le transistor Q4 fonctionne avec un courant très faible si l'on choisit convenablement les valeurs des résistances R13, R14, R15 et R16.

D'autre part, le transistor Q4 est polarisé par l'intermédiaire d'une résistance R12 et d'une résistance R17 en série avec une diode D2 de compensation en température qui peut elle aussi être remplacée par un transistor dont la base et l'émetteur sont court-circuités.

La sortie du montage est prise sur le collecteur du transistor Q4 par l'intermédiaire d'un condensateur C11. Le circuit constitué par la résistance R14 et le condensateur C11 sert à filtrer le signal détecté par le transistor Q4.

Le récepteur qui utilise l'amplificateur à fréquence intermédiaire selon l'invention comporte un détecteur d'une onde porteuse comme une antenne et qui produit une tension Ve appliquée à l'entrée de l'amplificateur à fréquence intermédiaire.

La sortie de l'étage à fréquence intermédiaire est connectée à un décodeur des informations transmises et détectées, dont la sortie est alors traitée.

Dans le cas d'une télécommande par exemple pour le verrouillage des portières d'un véhicule, le code de verrouillage est alors transmis vers des actionneurs qui activent les serrures.

## Revendications

1. Amplificateur à fréquence intermédiaire, caractérisé en ce qu'il comporte un premier (Q1) et un second (Q2) transistors d'amplification dont les chemins collecteur-émetteur sont connectés en série entre deux lignes d'alimentation (Va) de potentiel haut et de potentiel bas, avec des enroulements respectifs de deux transformateurs (T1,T2) accordés, de façon à ce que le signal d'entrée (Ve) progresse en cascade par la base du premier transistor (Q1), son collecteur, le transformateur (T1), la base du second transistor (Q2) et son collecteur jusqu'à la sortie (B) de l'amplificateur, tandis que les polarisations (R1,R2,D1,R3) des premier et second transistors (Q1,Q2) sont en série.

2. Amplificateur à fréquence intermédiaire selon la revendication 1, caractérisé en ce que le transistor (Q2) est découplé au point de vue haute fréquence à l'aide d'un condensateur (C3) connecté entre la masse et l'émetteur du transistor (Q2).

3. Amplificateur selon la revendication 1, caractérisé en ce qu'il comporte un dispositif de compensation en température connecté sur la base du transistor (Q1), le dispositif de compensation pouvant être constitué par une diode ou par un transistor.

4. Amplificateur selon la revendication 1, caractérisé en ce qu'il comporte un circuit de correction automatique de gain qui comporte un moyen de détection (40 Fig. 6) du niveau du signal de sortie (B) pouvant être constitué par un transistor (Q4) connecté à la sortie (B) de l'amplificateur et dont le collecteur comme sortie est connecté à l'électrode de commande (42) d'une source de courant commandable (41) pouvant être constituée par un transistor (Q3) dont le collecteur comme sortie, est connecté à l'entrée (-) d'un additionneur (34 Fig. 2) pouvant être constitué par une entrée d'un étage amplificateur antérieur comme l'émetteur du premier transistor (Q1) de façon à retirer plus ou moins de courant dans le premier transistor et, de ce fait, à retirer plus ou moins du niveau de tension de sortie du second transistor (Q2).

5. Récepteur de signal comme un signal de télécommande, caractérisé en ce qu'il comporte un amplificateur à fréquence intermédiaire selon l'invention.

## Patentansprüche

1. Zwischenfrequenzverstärker , **dadurch gekennzeichnet**, daß er einen ersten (Q1) und einen zweiten (Q2) Verstärkungstransistor umfaßt, deren Kollektor-Emitter-Strecken zwischen zwei Anschlußleitungen (Va) für hohe und niedrige Spannung mit entsprechenden Wicklungen von zwei abgestimmten Transformatoren (T1, T2) in Reihe geschaltet sind, so daß das Eingangssignal (Ve) in Kaskade durch die Basis des ersten Transistors (Q1), seinen Kollektor, den Transformator (T1), die Basis des zweiten Transistors (Q2) und seinen Kollektor bis zum Ausgang (B) des Verstärkers verläuft, während die Vorspannungen (R1, R2, D1, R3) des ersten und zweiten Transistors (Q1, Q2) in Reihe geschaltet sind.

2. Zwischenfrequenzverstärker nach Anspruch 1 , **dadurch gekennzeichnet**, daß der Transistor (Q2) hochfrequenztechnisch anhand eines Kondensators (C3) entkoppelt wird, der zwischen der Masse und dem Emitter des Transistors (Q2) geschaltet ist.

3. Verstärker nach Anspruch 1 , **dadurch gekennzeichnet**, daß er eine Temperaturausgleichvorrichtung umfaßt, die an die Basis des Transistors (Q1) angeschlossen ist, wobei die Ausgleichvorrichtung aus einer Diode oder einem Transistor bestehen kann.

4. Verstärker nach Anspruch 1 , **dadurch gekennzeichnet**, daß er eine automatische Verstärkungskorrekturschaltung umfaßt, die ein Mittel (40, Fig. 6) zur Erfassung des Pegels des Ausgangssignals (B) enthält, das an den Ausgang (B) des Verstärkers angeschlossen ist und dessen Kollektor ausgangsseitig an die Steuerelektrode (42) einer steuerbaren Stromquelle (41) angeschlossen ist, die aus einem Transistor (Q3) bestehen kann, dessen Kollektor ausgangsseitig mit dem Eingang (-) eines Addierers (34, Figr. 2) verbunden ist, der aus einem Eingang einer früheren Verstärkerstufe wie der Emitter des ersten Transistors (Q1) bestehen kann, um mehr oder weniger Strom im ersten Transistor zu entnehmen und dadurch mehr oder weniger vom Ausgangsspannungspegel des zweiten Transistors (Q2) zu entnehmen.

5. Signalempfänger, etwa für ein Fernbedienungssignal, **dadurch gekennzeichnet**, daß er einen erfindungsgemäßen Zwischenfrequenzverstärker umfaßt.

## Claims

1. Intermediate-frequency amplifier, characterised in that it has first (Q1) and second (Q2) amplification transistors whose connector-emitter paths are connected in series between two high-potential and low-potential supply lines (Va), with respective windings on two tuned transformers (T1, T2), so that the input signal (Ve) progresses in a cascade through the base of the first transistor (Q1), its collector, the transformer (T1), the base of the second transistor (Q2) and its collector as far as the output (V) of the amplifier, whilst the biasing components (R1, R2, D1, R3) of the first and second transistors (Q1, Q2) are in series.

2. Intermediate-frequency amplifier according to Claim 1, characterised in that the transistor (Q2) is decoupled from the high-frequency point of view by means of a capacitor (C3) connected between earth and the emitter of the transistor (Q2).

3. Amplifier according to Claim 1, characterised in that it includes a temperature compensation device connected to the base of the transistor (Q1), the compensation device being able to consist of a diode or a transistor.

4. Amplifier according to Claim 1, characterised in that it includes an automatic gain correction circuit which includes a means (40, Fig 6) of detecting the level of the output signal (B), which may consist of a transistor (Q4) connected to the output (B) of the amplifier and whose collector as an output is connected to the control electrode (42) for a controllable current source (41) which may consist of a transistor (Q3) whose collector as output is connected to the input (-) of an adder (34, Fig 2) which may consist of an input of a prior amplifier stage such as the emitter of the first transistor (Q1) so as to withdraw more or less current from the first transistor and thereby to withdraw more or less of the output voltage level of the second transistor (Q2).

5. Receiver for a signal such as a remote-control signal, characterised in that it includes an intermediate-frequency amplifier according to the invention.

FIG.1

FIG.2

FIG. 3

FIG. 4

FIG. 5

9

FIG.6

FIG.7